# FASCICULE DE BREVET EUROPEEN

(11) **EP 0 688 158 B1**
(45) Date de publication et mention de la délivrance du brevet: **05.03.1997**
(21) Numéro de dépôt: 95401139.1
(22) Date de dépôt: 17.05.1995
(51) Int. Cl.: H05K 9/00

(54) **Dispositif de protection d'un dispositif électronique sensible aux rayonnements électromagnétiques**
Schutzvorrichtung für eine elektromagnetische strahlungsempfindliche Vorrichtung
Protection device for an electromagnetic radiation-sensitive device

(30) Priorité: 18.05.1994 FR 9406047
(43) Date de publication de la demande: 20.12.1995
(73) Titulaire: SOCIETE NATIONALE D'ETUDE ET DE CONSTRUCTION DE MOTEURS D'AVIATION Snecma, F-75015 Paris (FR)
(72) Inventeur: Cosquer, Jean Marc, F-93200 Saint Denis (FR); Poirier, Robert, F-95150 Taverny (FR); Fabre, Alain Jean, F-92300 Levallois (FR)

(56) Documents cités:
- EP-A- 0 534 372
- GB-A- 2 101 811
- US-A- 4 739 453

## Description

L'invention concerne un dispositif de protection d'un dispositif électronique sensible aux rayonnements électromagnétiques. Elle peut s'appliquer à tout dispositif électronique et en particulier aux calculateurs électroniques embarqués à bord d'un aéronef pour lesquels les contraintes de coût et de poids sont importantes.

Pour protéger les dispositifs électroniques sensibles contre des rayonnements électromagnétiques, il est connu de les enfermer dans des boîtiers métalliques de blindage et de filtrer les signaux d'entrée/sortie. Généralement, la fonction filtrage est réalisée dans une première zone du boîtier séparée par une cloison interne d'une deuxième zone du boîtier dans laquelle sont localisés les circuits électroniques correspondant aux différentes fonctions du dispositif électronique.

Un dispositif de blindage de circuits électroniques montés sur une carte de circuit imprimé est connu du US-A-4739453. Le dispositif de blindage comporte un boîtier métallique muni d'une cloison interne destinée à séparer électromagnetiquement deux blocs de circuits électroniques. Les deux blocs de circuits électroniques sont localisés à l'interieur du dispositif de blindage.

La fonction de filtrage peut être effectuée au moyen de composants discrets montés par vis ou par soudure à travers des ouvertures pratiquées dans la cloison métallique interne. Cette solution est très coûteuse, nécessite un temps de montage important et présente une augmentation excessive de l'encombrement et du poids du dispositif électronique.

La fonction de filtrage peut également être effectuée en utilisant un circuit imprimé dédié à cette fonction. Cette solution nécessite une carte supplémentaire pour réaliser la fonction de filtrage et des moyens de connexions supplémentaires entre la carte de filtrage et la carte supportant le dispositif électronique. Or les connexions entre différents circuits imprimés sont délicates à mettre en oeuvre, sont coûteuses et augmentent l'encombrement du dispositif électronique.

L'invention a pour but de pallier les inconvénients des dispositifs connus et de réaliser un dispositif de protection efficace présentant un encombrement et un coût moindre sans augmenter le nombre de connecteurs internes ni le nombre de carte de circuit imprimé. Pour cela, le dispositif de protection comporte une seule carte de circuit imprimé sur laquelle sont disposés le dispositif électronique et des moyens de filtrage des signaux électriques d'entrée/sortie du dispositif électronique. La carte de circuit imprimé est disposée à l'intérieur d'un boîtier métallique et traverse perpendiculairement une cloison métallique interne de séparation entre une zone amont où règne des champs électromagnétiques et une zone aval blindée. Les signaux électriques d'entrée/sortie sont véhiculés de la zone amont vers la zone aval au moyen de lignes conductrices imprimées sur au moins une couche interne de la carte de circuit imprimée. Les moyens de filtrage des signaux électriques comportent des composants montés en surface au voisinage de la cloison métallique de séparation et des éléments capacitifs intégrés dans la carte de circuit imprimé à la traversée de la cloison. Les éléments capacitifs intégrés comportent une première armature constituée par une ligne conductrice et une deuxième armature constituée par une surface conductrice reliée à la masse mécanique. La liaison à la masse mécanique est réalisée par contact entre la surface conductrice et la cloison métallique de séparation. Avantageusement, la carte de circuit imprimé comporte en outre un plan conducteur interne relié à la masse mécanique, le plan conducteur formant avec chacune des lignes conductrices, des éléments capacitifs additionnels au passage de la cloison métallique de séparation.

Selon l'invention, le dispositif de protection d'un dispositif électronique sensible aux rayonnements électromagnétiques comporte :
- un boîtier métallique muni d'une cloison métallique interne de séparation entre une zone amont dans laquelle règne des champs électromagnétiques et une zone aval blindée, le boitier métallique et la cloison interne constituant une masse mécanique,
- une carte de circuit imprimé multicouches disposée à l'intérieur du boîtier métallique perpendiculairement à la cloison métallique interne, de manière à comprendre une première partie située dans la zone amont et une deuxième partie destinée à supporter le dispositif électronique et située dans la zone aval, la carte de circuit imprimé comportant au moins une couche interne sur laquelle sont imprimées des lignes conductrices destinées à véhiculer des signaux électriques de la zone amont vers la zone aval, et des moyens de filtrage des signaux électriques comportant des éléments capacitifs intégrés dans la carte de circuit imprimé à la traversée de la cloison interne, chaque élément capacitif intégré comportant une première armature constituée par l'une des lignes conductrices destinées à véhiculer des signaux électriques de la zone amont vers la zone aval et une deuxième armature constituée par une surface conductrice reliée à la masse mécanique par contact avec la cloison métallique interne, les lignes conductrices étant élargies au passage de la cloison interne de manière à augmenter l'effet capacitif.

D'autres caractéristiques et avantages de l'invention apparaitront clairement dans la suite de la description donnée à titre d'exemple non limitatif et faite en regard des figures annexées qui représentent :
- la figure 1, une vue en coupe d'un exemple de dispositif électronique disposé dans un boîtier métallique et comportant des moyens de filtrage, selon l'invention ;
- les figures 2a et 2b, deux vues détaillées respectivement en perspective et en coupe d'une carte de circuit imprimé au voisinage de la cloison métallique interne, montrant un exemple de cellule de filtrage, selon l'invention
- la figure 3, un schéma électrique correspondant à la cellule de filtrage de la figure 2b.

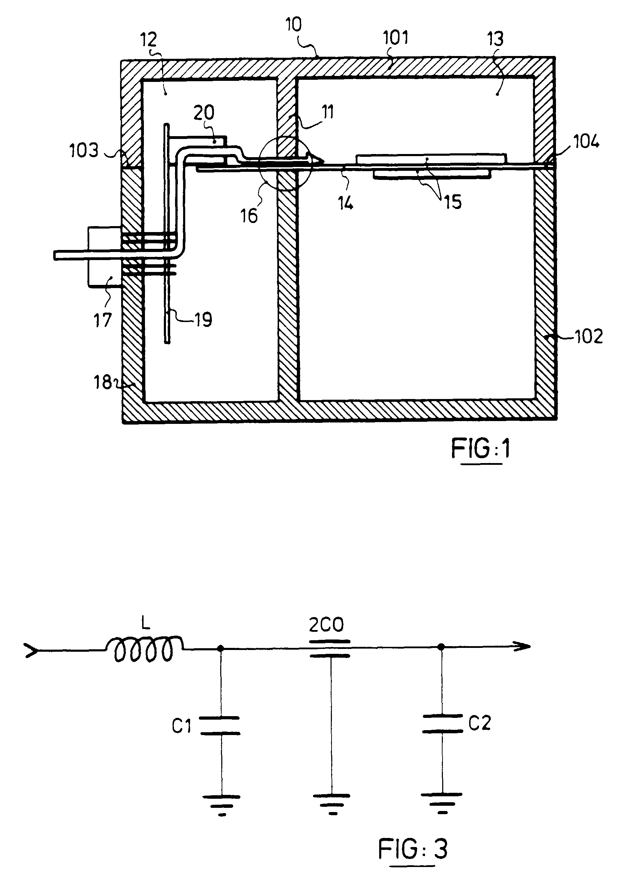

La figure 1 représente une vue en coupe d'un exemple de dispositif électronique disposé dans un boitier métallique et comportant des moyens de filtrage, selon l'invention.

Le boîtier métallique 10 constitué d'au moins deux cadres 101, 102 réunis par des plans de joint 103, 104, comporte une cloison métallique 11 interne délimitant deux zones 12, 13, la première zone 12, appelée zone amont, comportant des champs électromagnétiques, la deuxième zone 13, appelée zone aval, étant blindée. Le boitier 10 et la cloison métallique interne 11 constituent la masse mécanique de l'ensemble électronique.

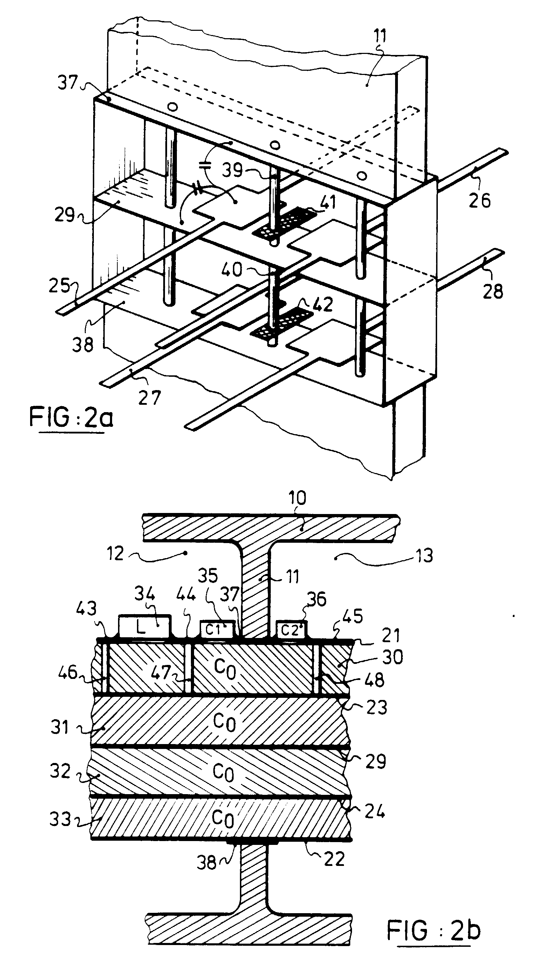

Une carte de circuit imprimé multicouches 14 supportant un dispositif électronique 15 et un dispositif de filtrage 16 des signaux d'entrée et de sortie, est disposée à l'intérieur du boitier 10 perpendiculairement à la cloison métallique interne 11. La carte de circuit imprimé 14 est alors pincée sur toute sa largeur par la cloison métallique interne 11 et comporte une première partie située dans la zone amont 12 et une deuxième partie destinée à supporter le dispositif électronique 15 et située dans la zone aval blindée 13. De cette manière, le dispositif électronique est entièrement localisé dans la zone blindée 13. Les moyens de filtrage 16 détaillés dans la suite de la description en liaison avec les figures 2a, 2b et 3, sont localisés au voisinage de la cloison métallique interne.

Les liaisons électriques d'entrée/sortie sont effectuées par l'intermédiaire d'un connecteur électrique externe 17 fixé sur une face avant 18 du boitier métallique. Les signaux électriques sont ensuite guidés par des pistes conductrices imprimées sur une carte intermédiaire 19, jusqu'à un connecteur interne 20 porté par la carte intermédiaire 19 et assurant les liaisons électriques avec les pistes conductrices du circuit imprimé multicouches 14. La carte intermédiaire 19 et le connecteur interne 20 sont localisés dans la zone amont 12 du boitier. Les figures 2a et 2b représentent deux vues détaillées respectivement en perspective et en coupe d'une carte de circuit imprimé au voisinage de la cloison métallique interne, montrant un exemple de cellule de filtrage, selon l'invention.

La carte de circuit imprimé comporte deux faces externes 21, 22, présentant des pistes conductrices sur lesquelles sont montés des composants électroniques, et des couches internes 23, 24 comportant des lignes conductrices 25, 26, 27, 28 destinées à guider des signaux électriques d'entrée/sortie de la zone amont 12 vers la zone aval 13. Un plan de masse interne 29 relié à la masse mécanique de l'ensemble électronique est disposé entre deux couches internes 23, 24 successives. Le plan de masse interne 29 est constitué par une couche conductrice s'étendant sur toute la surface du circuit imprimé et permet de séparer les signaux véhiculés sur deux couches successives 23, 24. Les différentes couches du circuit imprimé 21,23,29,24,22 sont isolées électriquement par des couches isolantes 30, 31, 32, 33 en matériau diélectrique. Les différentes pistes conductrices et le plan de masse interne 29 peuvent être réalisés, par exemple, en cuivre; le matériau diélectrique peut être réalisé, par exemple, en polyimide.

Les signaux électriques d'entrée/sortie sont découplés au moyen de cellules de filtrage disposées sur chaque ligne conductrice au voisinage de la cloison métallique.

Chaque cellule de filtrage comporte des composants 34, 35, 36 montés en surface sur les faces externes de la carte de circuit imprimé et deux éléments capacitifs intégrés dans l'épaisseur du circuit imprimé sous la cloison métallique 11. Chaque élément capacitif intégré comporte une armature constituée par une surface conductrice reliée à la masse mécanique et une armature constituée par la ligne conductrice 25, 26, 27, 28 véhiculant le signal à découpler.

Pour l'un des condensateurs intégrés, l'armature reliée à la masse mécanique est constituée par le plan de masse interne 29. Pour l'autre condensateur intégré, l'armature reliée à la masse mécanique est constituée par une surface conductrice 37, 38 localisée sur l'une des faces externes de la carte de circuit imprimé, sous la cloison métallique interne 11. La liaison à la masse est réalisée par contact avec la cloison interne 11. Pour augmenter l'effet de capacité, les lignes conductrices 25, 26, 27, 28 sont élargies au passage de la cloison métallique 11.

Au passage de la cloison métallique, la séparation entre deux signaux véhiculés par deux lignes conductrices successives situées sur une même couche interne est assurée par des trous métallisés 39, 40 percés dans l'épaisseur de la carte de circuit imprimé et reliés à la masse mécanique, chaque trou métallisé étant associé à une bande conductrice 41, 42 disposée sur la même couche que les deux lignes conductrices considérées et entre ces deux lignes. Cette configuration assure une faible diaphonie et une réduction de l'impédance de masse.

La figure 3 représente un schéma électrique correspondant à la cellule de filtrage de la figure 2b.

L'inductance L et les condensateurs C1 et C2 sont des composants montés en surface connectés sur des surfaces conductrices 43, 44, 45, 37. Les surfaces conductrices sont reliées par l'intermédiaire de trous métallisés, à la ligne conductrice à découpler. La surface conductrice 37 est pincée par la cloison métallique interne 11 qui assure ainsi la liaison à la masse de cette surface 37.

Les capacités C0 sont des capacités de traversée de cloison en parallèle et équivalentes à une capacité unique de valeur 2 CO.

La présente invention n'est pas limitée à l'exemple de réalisation précisément décrit, notamment le circuit imprimé peut comporter un nombre de couches et un nombre de lignes conductrices différent suivant le nombre de signaux électriques à véhiculer. Les cellules de filtrage peuvent comporter un nombre différent de composants montés en surface, ces composants pouvant être agencés dans des configurations différentes.

## Revendications

1. Dispositif de protection d'un dispositif électronique sensible aux rayonnements électromagnétiques, le dispositif de protection comportant:
- un boîtier métallique (10) muni d'une cloison métallique interne (11) de séparation entre une zone amont (12) dans laquelle règne des champs électromagnétiques et une zone aval (13) blindée, le boîtier métallique et la cloison interne (11) constituant une masse mécanique,
- une carte de circuit imprimé multicouches (14) disposée à l'intérieur du boîtier métallique (10) perpendiculairement à la cloison métallique interne (11), de manière à comprendre une première partie située dans la zone amont (12) et une deuxième partie destinée à supporter le dispositif électronique (15) et située dans la zone aval (13), la carte de circuit imprimé (14) comportant au moins une couche interne (23, 24) sur laquelle sont imprimées des lignes conductrices (25, 26, 27, 28) destinées à véhiculer des signaux électriques de la zone amont (12) vers la zone aval (13), et des moyens de filtrage (16) des signaux électriques comportant des éléments capacitifs intégrés dans la carte de circuit imprimé à la traversée de la cloison interne, chaque élément capacitif intégré comportant une première armature constituée par l'une des lignes conductrices (25, 26, 27, 28) destinées à véhiculer des signaux électriques de la zone amont (12) vers la zone aval (13) et une deuxième armature constituée par une surface conductrice (37, 38) reliée à la masse mécanique par contact avec la cloison métallique interne (11), les lignes conductrices (25, 26, 27, 28) étant élargies au passage de la cloison interne (11) de manière à augmenter l'effet capacitif.

2. Dispositif de protection selon la revendication 1, caractérisé en ce que la carte de circuit imprimé multicouches (14) comporte en outre au moins une deuxième couche interne (29) constituée par un plan conducteur interne relié à la masse mécanique, le plan conducteur formant avec chacune des lignes conductrices (25, 26, 27, 28) des éléments capacitifs internes additionnels au passage de la cloison métallique interne (11).

3. Dispositif de protection selon l'une quelconque des revendications 1 ou 2, caractérisé en ce que les moyens de filtrage (16) comportent en outre des composants montés en surface (34, 35, 36) localisés au voisinage de la cloison interne (11) sur au moins une face externe (21, 22) de la carte de circuit imprimé (14).

4. Dispositif de protection selon l'une quelconque des revendications précédentes, caractérisé en ce que, au passage de la cloison métallique (11), des trous métallisés (39, 40) reliés à la masse mécanique sont percés dans l'épaisseur de la carte de circuit imprimé entre deux lignes conductrices successives disposées sur une même couche interne, chaque trou métallisé étant associé à une bande conductrice (41, 42) disposée sur la même couche que les deux lignes conductrices.

5. Dispositif de protection selon l'une quelconque des revendications précédentes, caractérisé en ce qu'il comporte deux couches internes (23, 24) sur lesquelles sont imprimées des lignes conductrices (25, 26, 27, 28) destinées à véhiculer des signaux électriques de la zone amont (12) vers la zone aval (13), et un plan conducteur interne (29) relié à la masse mécanique, le plan conducteur (29) étant disposé entre les deux couches internes (23, 24).

## Patentansprüche

1. Schutzvorrichtung für eine gegen elektromagnetische Strahlung empfindliche elektronische Vorrichtung mit
- einem Metallgehäuse (10) mit einer inneren metallischen Zwischenwand (11) zur Trennung zwischen einer stromaufwärtigen Zone (12), in der elektromagnetische Felder herrschen, und einer abgeschirmten stromabwärtigen Zone (13), wobei das Metallgehäuse und die innere Zwischenwand (11) eine mechanische Masse bilden,
- eine mehrlagige gedruckte Schaltungsplatte (14), die im Innern des Metallgehäuses (10) senkrecht zu der inneren metallischen Zwischenwand (11) so angeordnet ist, daß sie einem ersten Teil umfaßt, der sich in der stromaufwärtigen Zone (12) befindet, und einen zweiten Teil, der den Träger der elektronischen Vorrichtung (15) bildet und in der stromabwärtigen Zone (16) liegt, wobei die gedruckte Schaltungsplatte (14) wenigstens eine innere Schicht (23, 24) besitzt, auf der Leiterbahnen (25, 26. 27, 28) zur Übertragung von elektrischen Signalen aus der stromaufwärtigen Zone (12) in die stromabwärtige Zone (13) aufgebracht sind, sowie Mittel (16) zur Filterung der elektrischen Signale, die kapazitive Elemente umfassen, die an dem Durchtritt der inneren Zwischenwand in die gedruckte Schaltungsplatte integriert sind, wobei jedes der integrierten kapazitiven Elemente einen von einer der Leiterbahnen (25. 26, 27, 28) gebildeten ersten Anschluß und einen zweiten Anschluß aufweist, der von einer mit der mechanischen Masse durch Kontakt mit der metallischen Zwischenwand (11) verbundenen leitfähigen Fläche gebildet wird, wobei die Leiterbahnen (25, 26, 27, 28) an dem Durchgang der inneren Zwischenwand (11) so verbreitert sind, daß sie den kapazitiven Effekt vergrößern.

2. Schutzvorrichtung nach Anspruch 1,
**dadurch gekennzeichnet**,
daß die mehrlagige gedruckte Schaltungsplatte (14) außerdem wenigstens eine zweite innere Schicht (29) aufweist, die von einer mit der mechanischen Masse verbundenen inneren leitfähigen Fläche gebildet wird, wobei die leitfähige Fläche mit den einzelnen Leiterbahnen (25, 26, 27, 28) zusätzliche innere kapazitive Elemente am Durchgang der inneren metallischen Zwischenwand (11) bildet.

3. Schutzvorrichtung nach einem der Ansprüche 1 oder 2,
**dadurch gekennzeichnet**,
daß die Filtermittel (16) außerdem oberflächenmontierte Komponenten (34. 35, 36) umfassen, die in der Nähe der inneren Zwischenwand (11) auf wenigstens einer Außenfläche (21, 22) der gedruckten Schaltungsplatte (14) angeordnet sind.

4. Schutzvorrichtung nach einem der vorhergehenden Ansprüche,
**dadurch gekennzeichnet**,
daß am Durchgang der metallischen Zwischenwand (11) metallisierte Löcher (39, 40) ausgebildet sind, die zwischen zwei aufeinanderfolgenden, auf ein und derselben inneren Schicht angeordneten Leiterbahnen durch die Dicke der gedruckten Schaltungsplatte verlaufen und mit der mechanischen Masse verbunden sind, wobei jedes metallisierte Loch mit einem leitfähigen Streifen (41, 42) in Verbindung steht, der auf derselben Schicht angeordnet ist wie die beiden Leiterbahnen.

5. Schutzvorrichtung nach einem der vorhergehenden Ansprüche,
**dadurch gekennzeichnet**,
daß sie zwei innere Schichten (23, 24) aufweist, auf denen Leiterbahnen (25, 26, 27, 28) zur Übertragung von elektrischen Signalen aus der stromaufwärtigen Zone (12) in die stromabwärtige Zone (13) aufgebracht sind, und daß zwischen den beiden inneren Schichten (23, 24) eine mit der mechanischen Masse verbundene innere leitfähige Fläche (29) angeordnet ist.

## Claims

1. A device for shielding an electronic device sensitive to electromagnetic radiations, the shielding device comprising:
a metal casing (10) having an internal metal partition (11) separating an upstream zone (12) in which electromagnetic fields are operative and a screened downstream zone (13), the metal casing and the internal partition (11) forming an earth;
a multilayer printed circuit board (14) diposed in the metal casing (10) perpendicularly to the partition (11) so as to have a first part disposed in the upstream zone (12) and a second part which is adapted to support the electronic device (15) and which is disposed in the downstream zone (13), the printed circuit board (14) comprising at least one internal layer (23, 24) on which conductive tracks (25 - 28) are printed for carrying electric signals from the upstream zone (12) towards the downstream zone (13) and electric signal filter means (16) comprising capacitative elements incorporated in the printed circuit board at the passage through the partition (11), each incorporated capacitative element comprising a first plate, in the form of one of the conductive tracks (25 - 28) for carrying electric signals from the upstream zone (12) towards the downstream zone (13), and a second plate, in the form of a conductive surface (37, 38) earthed by contact with the partition (11), the tracks (25 - 28) widening at the passage through the partition (11) so as to increase the capacitative effect.

2. A shielding device according to claim 1, characterised in that the multilayer printed circuit boad (14) also comprises at least one second internal layer (29) in the form of an earthed internal conductive plane, which cooperates with each of the conductive tracks (25 - 28) to form additional internal capacitative elements at the passage through the partition (11).

3. A shielding device according to claim 1 or 2, characterised in that the filter means (16) also comprise surface-mounted components (34 - 36) disposed near the partition (11) on at least one external surface (21, 22) of the printed circuit board (14)

4. A shielding device according to any of the previous claims, characterised in that at the passage through the partition (11) earthed metallised holes (39, 40) are pierced in the thickness of the printed circuit board between two consecutive conductive tracks disposed on a single internal layer, each metallised hole being associated with a conductive strip (41, 42) disposed on the same layer as the two conductive tracks.

5. A shielding device according to any of the previous claims, characterised in that it comprises: two internal layers (23, 24) on which conductive tracks (25 - 28) for carrying electric signals from the upstream zone (12) to the downstream zone (13) are printed, and an earthed internal conductive plane (29) disposed between the two internal layers (23, 24).
